# EUROPEAN PATENT APPLICATION

(11) **EP 4 585 651 A1**
(43) Date of publication of application: **16.07.2025**
(21) Application number: 23872373.8
(22) Date of filing: 26.09.2023
(51) Int. Cl.: C08L 83/07, B32B 27/00, B32B 27/18, C08K 3/04, C08L 83/04, C08L 83/05

(54) **HOT MELT TYPE ORGANOPOLYSILOXANE COMPOSITION FOR FORMING ELECTRODE LAYER, MULTILAYER BODY COMPRISING ELECTRODE LAYER, USE OF SAME AND METHOD FOR PRODUCING SAME**

(30) Priority: 29.09.2022 JP 2022156903
(71) Applicant: Dow Toray Co., Ltd., Tokyo 140-8617 (JP)
(72) Inventor: FUKUI Hiroshi, Ichihara-shi Chiba 299-0108 (JP)
(74) Representative: Murgitroyd & Company
(86) International application number: PCT/JP2023/035044
(87) International publication number: WO 2024/071151

(57) **Abstract**

To provide an electrode layer-forming composition, a laminate body, uses thereof, and a production method thereof, which can form an electrode layer having viscoelastic properties sufficient for practical use, which can be coated with a hot-melt process, which has excellent adhesion to a dielectric layer, conformability, and shape retention properties to the resulting electrode layer, and which is unlikely to cause problems such as peeling or defects in the electrode layer even when used in a transducer.

**SOLUTION**

A hot-melt electrode layer-forming organopolysiloxane composition containing (A) a linear organopolysiloxane, (B) an MQ type organopolysiloxane resin having a weight average molecular weight of 5000 or more in terms of a polystyrene standard, and (E) conductive fine particles, wherein the composition is non-fluid at 25°C, has heat melting properties, and the amount of component (B) in the composition is 45 mass% or more relative to the entire composition.

## Description

### TECHNICAL FIELD

The present invention relates to a hot-melt electrode layer-forming organopolysiloxane composition that is non-fluid to solid at 25°C and has fluidity upon heating, a laminate body including an electrode layer formed using the composition, uses thereof, and a production method and production device thereof.

### BACKGROUND ART

Organopolysiloxane cured materials having a polysiloxane skeletal structure have excellent transparency, electrical insulation, heat resistance, cold resistance, and the like, can have improved electrical activity, if so desired, by introducing a high dielectric functional group such as a fluoroalkyl group or the like, and can be easily processed into a film or sheet. Therefore, the organopolysiloxane cured materials used in various applications such as adhesive films used in various electric and electronic devices and electroactive films used in actuators and other transducer devices are classified into a hydrosilylation reaction curing type, condensation reaction curing type, peroxide curing type, and the like, based on the curing mechanism. In particular, organopolysiloxane cured material films using hydrosilylation reaction curing type curable organopolysiloxane compositions are widely used because they are quick curing when left at room temperature or heated, with no generation of byproducts.

Meanwhile, when an organopolysiloxane cured material film is used as an electronic member such as a touch panel or the like, an electronic component for a display device, and particularly as a transducer material for a sensor, actuator, or the like, an electrode layer must be provided on an electroactive film serving as a dielectric layer. For example, Non-Patent Documents 1 and 2 propose forming an electrode layer with a conductive filler added in a silicone elastomer matrix with excellent flexibility to form an electrode layer with excellent tracking to a dielectric layer.

However, when attempting to form an electrode layer with a conductive filler added on an organopolysiloxane cured film, which is an electroactive film, particularly with displacement of the dielectric layer (e.g., expansion and contraction of actuators, and the like), interface peeling of the dielectric layer and electrode layer may occur, leading to inferior current flow and reduced reliability as an actuator. The present applicants have proposed in Patent Document 1 and the like that an electrode layer, which is an organopolysiloxane cured film, is formed on an electroactive film (=dielectric layer) by applying a curable organopolysiloxane composition containing a conductive filler onto the electroactive film, which is an organopolysiloxane cured film, and have also proposed a laminate body (Patent Document 2) in which a functional group involved in a common curing reaction for forming a chemical bond at the interface is used in a dielectric layer/electrode layer-forming organopolysiloxane composition to improve the conformability of the electrode surface, as a transducer material for actuators and the like.

### RELATED ART DOCUMENTS

### [NON-PATENT DOCUMENTS]

Non-Patent Document 1: Kujawski, M.; Pearse, J. D.; Smela, E. Carbon 2010, 48, 2409-2417.
Non-Patent Document 2: Rosset, S.; Shea, H. R. Appl. Phys. A2013, 110, 281-307.

### PATENT DOCUMENTS

Patent Document 1: International Patent Publication WO 2014/105959
Patent Document 2: International Patent Publication WO 2022/004462

### SUMMARY OF THE INVENTION

### PROBLEM TO BE SOLVED BY THE INVENTION

However, the present inventors have identified potential problems in these processes. In other words, all of the known electrode-forming compositions are applied to coating processes that use a liquid or a solvent, and cannot be applied to recent solvent-less processes or electrode printing processes that aim to reduce the environmental load and improve the performance of actuators and the like. The applicable processes are limited, so there are potential problems in industrial deployment. Furthermore, these electrode-forming compositions are liquid compositions, so there is expectation that providing a composition with superior handling properties in terms of transportation, use and storage stability will promote further industrial use.

On the other hand, conventional electrode-forming compositions are applied by a coating process using a liquid or solvent, so the uniformity of the formed electrode and a practically acceptable level of conformability to the base material are guaranteed to a certain degree. However, if the electrode-forming composition is in a solvent-free or non-flowable form, the composition may become non-uniform during application, or the resulting electrode layer may not have sufficient viscoelasticity, even if an electrode layer is provided on a dielectric layer. In particular, when the composition is applied to a transducer that has a large physical displacement, there is a major concern that the electrode may not be able to maintain the shape and may not be able to demonstrate sufficient performance.

The present invention has been made to solve the aforementioned problems, and an object thereof is to provide an electrode layer-forming composition capable of forming an electrode layer having viscoelastic properties sufficient for practical use, which can be used in a substantially solvent-free process, and is applicable to a variety of processes including an electrode printing process, the composition itself is non-fluid to solid and therefore has excellent handling properties and storage stability, can be applied by a heat-melting (hot-melt) process, and the resulting electrode has extremely excellent heat resistance, durability, adhesion to a dielectric layer, conformability and shape retention, and is unlikely to cause problems such as peeling of the electrode layer even when used in a transducer that assumes a high degree of physical displacement such as an actuator. Furthermore, an object of the present invention is to provide a laminate body using the composition, and a use and a production method thereof.

### MEANS FOR SOLVING THE PROBLEM

As a result of extensive research, the present inventors discovered that the aforementioned object can be achieved by a hot-melt electrode layer-forming organopolysiloxane composition, comprising:
(A) a linear organopolysiloxane;
(B) an organopolysiloxane resin having a weight average molecular weight of 5000 or higher in terms of a polystyrene standard, and containing siloxane units (M units) expressed by R₃SiO_{1/2} (where each R independently represents a monovalent organic group) and siloxane units (Q units) expressed by SiO_{4/2} in each molecule; and
(E) conductive fine particles,
wherein the hot-melt electrode layer-forming organopolysiloxane composition is non-flowable at 25°C and is heat meltable, and the amount of component (B) in the composition is 45 mass% or more based on the entire composition, and thus the present invention was achieved. With ordinary silicone compositions, an electrode layer with sufficient viscoelastic properties for practical use cannot easily be obtained by simply designing a hot-melt composition. However, the above problem can be satisfactorily solved by using the aforementioned specific components and satisfying the range of amounts used.

From the standpoint of solving the problem, the hot-melt electrode layer-forming organopolysiloxane composition according to the present invention is preferably substantially solvent-free, and does not contain a detectable amount of solvent. Furthermore, the resulting electrode layer can have good viscoelasticity and excellent electrical conductivity, so the conductive fine particles (E) are preferably fine particles containing at least one type of conductive carbon selected from carbon nanotubes (CNT), conductive carbon black, graphite, and vapor grown carbon (VGCF), and a certain amount of fibrous conductive carbon such as single-walled carbon nanotubes (SWCNT) is preferably used.

Furthermore, the aforementioned problems are also solved by a laminate body having a structure in which (L2) an electrode layer made of the aforementioned hot-melt electrode layer-forming organopolysiloxane composition is laminated on at least one surface of (L1) an organopolysiloxane cured film, which is a dielectric layer, as well as uses thereof (including a transducer member, a transducer, an electronic component, or a display device).

Furthermore, the aforementioned object can be achieved by a method for producing a laminate body, including:
Step I: a step of obtaining an organopolysiloxane cured film as a dielectric layer by curing a curable organopolysiloxane composition that provides a dielectric layer by curing into a film shape; and
Step II: a step of applying the hot-melt electrode layer-forming organopolysiloxane composition after heat melting, onto the organopolysiloxane cured film or a precursor thereof, which has been subjected to Step I, to form an electrode layer, simultaneously with or after Step I,
as well as a method for forming an electrode layer using a transducer member, including the aforementioned method of production.

### EFFECT OF THE INVENTION

The present invention can provide an electrode layer-forming composition capable of forming an electrode layer having viscoelastic properties sufficient for practical use, which can be used in a substantially solvent-free process, and is applicable to a variety of processes including printing, wherein the composition itself is non-fluid to solid and therefore has excellent handling properties and storage stability, and the resulting electrode has extremely excellent heat resistance, durability, adhesion to a dielectric layer, conformability and shape retention, and is unlikely to cause problems such as peeling of the electrode layer even when used in a transducer that assumes a high degree of physical displacement such as an actuator. Furthermore, an object of the present invention is to provide a laminate body using the composition, and a use and a production method thereof. In particular, the present invention can provide a laminate body and a method of production that enable flexible process design including solvent-free processes, and that is less susceptible to interfacial peeling with the organopolysiloxane cured film, which is the dielectric layer, that has excellent reliability in applications such as actuators and the like, and that is free of electrical conductivity problems.

### DESCRIPTION OF THE PREFERRED EMBODIMENTS

[Hot-melt electrode layer-forming organopolysiloxane composition] First, the hot-melt electrode layer-forming organopolysiloxane composition according to the present invention (hereinafter sometimes referred to as "the present composition") will be described. The present composition includes:
(A) a linear organopolysiloxane;
(B) an organopolysiloxane resin having a weight average molecular weight of 5000 or higher in terms of a polystyrene standard, and containing siloxane units (M units) expressed by R₃SiO_{1/2} (where each R independently represents a monovalent organic group) and siloxane units (Q units) expressed by SiO_{4/2} in each molecule; and
(E) conductive fine particles,
wherein the hot-melt electrode layer-forming organopolysiloxane composition is non-flowable at 25°C and is heat meltable, and the amount of component (B) in the composition is 45 mass% or more based on the entire composition.

Herein, "being heat meltable" means that the material has a softening point of 50°C or higher, a melt viscosity at 150°C (preferably a melt viscosity of less than 1000 Pa·s), and has flow properties. On the other hand, a softening point of 200°C or higher is defined as "not being heat meltable" because this level is above the general operating temperature for molding applications and the like. It should be noted that in the present specification, heat meltable is sometimes referred to as "hot-melt". In addition, the composition is heat meltable, and thus is specified as a "hot-melt" composition.

The composition is non-fluid at 25°C. Here, the term "non-fluid" means that it is not deformed or flowed in a no-load state and is preferably not deformed or flowed in a no-load state at 25°C when it is molded into a pellet, a tablet, or the like. Such a non-fluid can be evaluated, for example, by placing a molded product of the composition on a hot plate at 25°C and substantially not deforming or flowing under no load or constant weight. This is because when non-fluid at 25°C, shape retention at this temperature is favorable and the surface tackiness is low.

The softening point of the composition is preferably 100°C or less. Such a softening point means the temperature at which the deformation amount in the height direction is 1 mm or more when the deformation amount of the composition is measured after the load is removed by continuing to press the hot plate with a load of 100 grams for 10 seconds from above.

From the viewpoint of uniform application properties based on the viscoelasticity and heat meltability of the electrode layer obtained using the present composition, the ratio (G'_{110°C}/G'_{25°C}) of the shear storage modulus at 110°C (G'_{110°C}) to the shear storage modulus at 25°C (G'_{25°C}) of the composition before electrode formation (including particularly before the curing reaction) is 0.5 or less, more preferably in a range of 0.01 to 0.50, and particularly preferably in a range of 0.02 to 0.45. It should be noted that the (G'_{110°C}/G'_{25°C}) value of the composition after electrode formation (particularly including after the curing reaction) is also preferably 0.5 or less, and may be and is preferably in a range of 0.05 to 0.45. On the other hand, if the value of (G'_{110°C}/G'_{25°C}) of the composition before or after electrode formation (especially after curing) exceeds 0.5, the temperature dependency of the viscoelasticity of the electrode layer will be small, and performance problems may occur, such as the inability to improve processability by heating or the inability to maintain the shape of the electrode layer.

The viscoelasticity of the electrode layer obtained by using the present composition is not particularly limited, but after the electrode layer is formed, the shear storage modulus at 25°C (G'_{25°C}) may be in a range of 1.0 x 10⁵ to 7.5 x 10⁶ Pa, and in addition to the aforementioned temperature dependency, viscoelasticity in the electrode layer that is sufficient for practical use can be achieved. In addition, from the viewpoint of the viscoelasticity of the electrode layer obtained using the present composition, the value of tan δ of the composition at 25°C before or after electrode formation (particularly after curing) is particularly preferably 0.30 or more, and the value of tan δ of the composition before electrode formation is particularly preferably in a range of 0.35 to 0.99. If the viscoelasticity of the present composition or an electrode layer thereof satisfies the above conditions, an electrode layer can be formed with viscoelastic properties sufficient for practical use and which is unlikely to cause problems such as peeling or defects in the electrode layer.

In order for the composition to have heat melting properties and to exhibit excellent viscoelasticity in the electrode layer as described above, the present composition includes at least:
(A) a linear organopolysiloxane;
(B) an organopolysiloxane resin having a weight average molecular weight of 5000 or higher in terms of a polystyrene standard, and containing siloxane units (M units) expressed by R₃SiO_{1/2} (where each R independently represents a monovalent organic group) and siloxane units (Q units) expressed by SiO_{4/2} in each molecule; and
(E) conductive fine particles.
wherein the amount of component (B) in the composition is 45 mass% or more based on the entire composition. It should be noted that the present composition may be a curing reactive composition, and may form an electrode layer as a curing reactant after heating and melting, or may form an electrode layer as a non-fluid solid layer (including so-called dry-up) after heating and melting, and is not particularly limited.

### [Component (A)]

Component (A) is a linear organopolysiloxane, which, when used in combination with a certain amount of component (B), provides heat meltability for the composition as a whole, and also provides favorable temperature dependency of viscoelasticity in the resulting electrode layer. Examples of the chain organopolysiloxanes include those having a linear structure or a branched-chain structure having a small number of branching points, but from a practical standpoint, linear organopolysiloxanes are particularly preferred. Use of a highly branched organopolysiloxane is not preferred because achieving heat meltability may not be possible, or the electrode layer might not have viscoelasticity.

Component (A) does not have to have a curing reactive functional group, but (A1) is preferably a linear organopolysiloxane having a curing reactive functional group containing a carbon-carbon double bond at least at both terminals of the molecular chain, regardless of whether the composition as a whole has curing reactivity. The curing reactive functional group containing a carbon-carbon double bond is a curing reactive group selected from an alkenyl group having 2 to 20 carbon atoms, such as a vinyl group or the like; and a (meth)acryl group-containing group, such as a 3-acryloxypropyl group, a 3-methacryloxypropyl group, and the like, and an alkenyl group having 2 to 6 carbon atoms is particularly preferred.

The linear organopolysiloxane in component (A) may contain a group selected from monovalent hydrocarbon groups that do not have a carbon-carbon double bond in a molecule, hydroxyl groups, and alkoxy groups with 1 to 3 carbon atoms. Furthermore, a portion of the hydrogen atoms of the monovalent hydrocarbon group may be substituted with a halogen atom or a hydroxyl group. Industrially, a methyl group, a phenyl group, a hydroxyl group, and an alkoxy group are preferred.

Preferably, component (A1) is a linear organopolysiloxane having a siloxane unit expressed by

(Alk)R²₂SiO_{1/2}

(where Alk represents an alkenyl group having two or more carbon atoms) on both ends of a molecular chain, and where other siloxane units are essentially only a siloxane unit expressed by R²₂SiO_{2/2}. In the formula, R² is a group selected from the monovalent hydrocarbon groups not having a carbon-carbon double bond, hydroxyl groups, and alkoxy groups. Industrially, methyl groups, phenyl groups, hydroxyl groups, and alkoxy groups are preferred, and all may be methyl groups. Furthermore, the degree of siloxane polymerization of component (A1) is within a range of 7 to 1002 including terminal siloxane units, but may be within a range of 102 to 902.

### [Component (B)]

Component (B) is one of the characteristic components of the present invention, which imparts hot-melt properties to the composition as a whole, and when used together with component (A) in a certain quantitative range, imparts hot-melt properties sufficient for practical use to the composition, and thus the resulting electrode has excellent heat resistance, durability, adhesion to the dielectric layer, conformability, and shape retention. Specifically, component (B) is an organopolysiloxane resin having a weight average molecular weight of 5000 or more in terms of a polystyrene standard, as measured by gel permeation chromatography (GPC) using an organic solvent such as toluene or xylene, and having M units and Q units in the molecule.

The first feature of component (B) is being a high molecular weight organopolysiloxane resin having a weight average molecular weight of 5000 or more. From the viewpoint of hot-melt properties and shape retention of the resulting electrode, the weight average molecular weight of component (B) is preferably 5500 or more, or 6000 or more, and industrially, a range of 5500 to 100,000, or 6000 to 50,000 is particularly preferred. On the other hand, when the weight average molecular weight of component (B) is less than the aforementioned lower limit (in other words, a low molecular weight organopolysiloxane resin), achieving sufficient temperature dependency of viscoelasticity, hot-melt properties, and shape retention of the electrode as a whole composition may not be possible, even if a certain amount or more of component (B) containing M/Q units is added.

Component (B) is organopolysiloxane resin is expressed by the following formula that contains siloxane units (M units) expressed by R₃SiO_{1/2} (wherein each R independently represents a monovalent organic group) and siloxane units (Q units) expressed by SiO_{4/2} in each molecule, and may optionally contain siloxane units selected from R₂SiO_{2/2} (D units) and RSiO_{3/2} (T units), and has the following average unit formula:

(R₃SiO_{1/2})p(R₂SiO_{2/2})q(RSiO_{3/2})r(SiO_{4/2})s(XO_{1/2})t

R is a monovalent organic group, which may be a curing reactive group containing a carbon-carbon double bond, or may be a group selected from monovalent hydrocarbon groups not having a carbon-carbon double bond in the molecule, hydroxyl groups, or alkoxy groups.

Specifically, examples of the curing reactive group containing a carbon-carbon double bond represented by R include curing reactive groups selected from alkenyl groups having 2 to 20 carbon atoms, such as vinyl groups, allyl groups, butenyl groups, pentenyl groups, hexenyl groups, heptenyl groups, octenyl groups, nonenyl groups, decenyl groups, undecenyl groups, and dodecenyl groups; acrylic groups-containing groups such as 3-acryloxypropyl groups and 4-acryloxybutyl groups; and methacrylic group-containing groups such as 3-methacryloxypropyl groups and 4-methacryloxybutyl groups, and the like.

Similarly, examples of the monovalent hydrocarbon group not having a carbon-carbon double bond represented by R include: alkyl groups such as methyl groups, ethyl groups, propyl groups, butyl groups, pentyl groups, hexyl groups, heptyl groups, octyl groups, nonyl groups, decyl groups, undecyl groups, and dodecyl groups; aryl groups such as phenyl groups, tolyl groups, xylyl groups, naphthyl groups, anthracenyl groups, phenanthryl groups, and pyrenyl groups; aralkyl groups such as benzyl groups, phenethyl groups, naphthyl ethyl group, naphthyl propyl groups, anthracenyl ethyl groups, phenanthryl ethyl groups, and pyrenyl ethyl groups; and groups obtained by substituting hydrogen atoms of these aryl groups or aralkyl groups with alkyl groups (such as methyl groups and ethyl groups), alkoxy groups (such as methoxy groups and ethoxy groups), or halogen atoms (such as chlorine atoms and bromine atoms).

In the above average unit formula, X represents a hydrogen atom or an alkyl group having 1 to 3 carbon atoms, and OX represents a hydroxyl group or an alkoxy group having 1 to 3 carbon atoms. These hydrolyzable functional groups may be hydroxyl groups remaining in the resin during the synthesis of the organopolysiloxane resin, or may have a structure in which hydroxyl groups in the resin have been blocked by treatment with a silazane compound or the like during synthesis.

Here, p is a positive number, q and r are 0 or positive numbers, s is a positive number, t/(p+q+r+s) is a number within a range of 0 to 0.4, and (p+q)/(r+s) is preferably within a range of 0.5 to 2.0. Organopolysiloxane resins in which q and r are 0, and which are composed only of M units and Q units are particularly preferred.

Component (B) in the present invention may be one or more type of organopolysiloxane resin selected from:
(B1) organopolysiloxane resins having a curing reactive group containing a carbon-carbon double bond in each molecule; and
(B2) organopolysiloxane resins not having a curing reactive group containing a carbon-carbon double bond in each molecule.

However, from the viewpoint of improving curing reactivity and temperature dependency of the viscoelasticity of the resulting electrode layer, as well as the shape retention of the dielectric layer, both components (B1) and (B2) are preferably included. Specifically, components (B1) and (B2) may be used in combination at a mass ratio range of 5:95 to 95:5, but are preferably used in a combination at a mass ratio range of 5:95 to 50:50.

The organopolysiloxane resin of component (B1) is preferably an alkenyl group-containing organopolysiloxane resin having the aforementioned weight average molecular weight, containing the aforementioned M units and Q units, in which at least a portion of R is an alkenyl group such as a vinyl group or a hexenyl group, and where the amount of vinyl (CH₂=CH-) groups is in a range of 1.0 to 5.0 mass%, preferably 1.2 to 3.5 mass%. **It** should be noted that R groups other than the alkenyl groups are not particularly limited, but from an industrial standpoint, the other R groups may be an alkyl group such as a methyl group, or an aryl group such as a phenyl group, or the like. **It** should be noted that the preferred ratios and amounts of the M units, Q units and optionally included (XO_{1/2}) units are as described above.

The organopolysiloxane resin which is component (B2) is preferably an organopolysiloxane resin having the aforementioned weight average molecular weight, containing the aforementioned M units and Q units, in which R is a group selected from alkyl groups such as a methyl group or aryl groups such as a phenyl group, and which does not contain a curing reactive group containing a carbon-carbon double bond in the molecule. **It** should be noted that the preferred ratios and amounts of the M units, Q units and optionally included (XO_{1/2}) units are as described above.

### [Component (C)]

Component (C) is an optional component of the present composition and is a crosslinking agent capable of forming a cured product by a hydrosilylation reaction between curing reactive groups containing a carbon-carbon double bond in component (A) or component (B) in the presence of component (D). It should be noted that if the present composition does not have curing reactivity and for example, an electrode is formed simply by drying after hot-melting, the use of components (C) and (D) is not necessary. On the other hand, when the present composition is used to form an electrode as a cured product after hot-melting, components (C) and (D) are preferably included, assuming the presence of a curing reactive group containing a carbon-carbon double bond in component (A) or component (B).

Examples of component (C) include 1,1,3-3-tetramethyldisiloxane, 1,3,5,7-tetramethylcyclotetrasiloxane, tris(dimethylhydrogensiloxy)methylsilane, tris(dimethylhydrogensiloxy)phenylsilane, methylhydrogenpolysiloxanes blocked at both ends of a molecular chain with a trimethylsiloxy group, dimethylsiloxane/methylhydrogensiloxane copolymers blocked at both ends of a molecular chain with a trimethylsiloxy group, dimethylpolysiloxane blocked at both ends of a molecular chain with a dimethylhydrogensiloxane group, dimethylsiloxane/methylhydrogensiloxane copolymers blocked at both ends of a molecular chain with a dimethylhydrogensiloxane group, methylhydrogensiloxane/diphenylsiloxane copolymers blocked at both ends of a molecular chain with a trimethylsiloxy group, methylhydrogensiloxane/diphenylsiloxane/dimethylsiloxane copolymers blocked at both ends of a molecular chain with a trimethylsiloxy group, hydrolytic condensates of a trimethylsilane, copolymers containing (CH₃)₂HSiO_{1/2} units and SiO_{4/2} units, copolymers containing (CH₃)₂HSiO_{1/2} units, SiO_{4/2} units, and (C₆H₅)SiO_{3/2} units, and mixtures of two or more types thereof.

The amount of component (C) used is preferably an amount where the silicon-bonded hydrogen atoms are within a range of 0.0 to 10 mols, more preferably 0.0 to 5.0 mols, and particularly preferably 0.0 to 1.5 mols, or a range of 0.0 to 0.10, with regard to 1 mol of carbon-carbon double bonds in the composition. **It** should be noted that in the case where at least a portion of component (A) is component (A1) and at least a portion of component (B) is component (B1), and the composition forms an electrode upon curing, the amount of component (C) used may be an amount that provides 0.1 to 5.0 mol, 0.1 to 1.5 mol, or 0.1 to 1.00 mol of silicon-bonded hydrogen atoms per mole of carbon-carbon double bonds in the composition. In particular, when the amount of component (C) used is equal to or less than the upper limit, the mechanical strength and temperature dependency of the cured product can be easily designed to be within a practically appropriate range, and there is an advantage in that an electrode having excellent conformability and shape retention of the electrode layer to the dielectric layer can be easily obtained.

### [Component (D)]

Component (D), which may have any configuration similar to component (C), is a catalyst that promotes the hydrosilylation reaction between component (C) and a curing reactive group containing a carbon-carbon double bond in the composition. Examples of catalysts include platinum-based catalysts, rhodium-based catalysts, palladium-based catalysts, nickel-based catalysts, iridium-based catalysts, ruthenium-based catalysts, and iron-based catalysts, but a platinum-based catalyst is preferable. Examples of platinum based catalysts include platinum based compounds, such as platinum fine powders, platinum black, platinum-supporting silica fine powders, platinum-supporting activated carbon, chloroplatinic acids, alcohol solutions of chloroplatinic acids, olefin complexes of platinum, alkenylsiloxane complexes of platinum, and the like. Alkenylsiloxane complexes of platinum are particularly preferable. Exemplary alkenylsiloxanes include: 1,3-divinyl-1,1,3,3-tetramethyldisiloxane; 1,3,5,7-tetramethyl-1,3,5,7-tetravinylcyclotetrasiloxane; alkenyl siloxanes obtained by substituting a portion of the methyl groups of the alkenylsiloxanes with an ethyl group, a phenyl group, or the like; and alkenylsiloxanes obtained by substituting a portion of the vinyl groups of these alkenylsiloxanes with an allyl group, a hexenyl group, or the like. The platinum-alkenyl siloxane complex has favorable stability, so 1,3-divinyl-1,1,3,3-tetramethyldisiloxane is particularly preferable. Furthermore, the stability of the platinum-alkenylsiloxane complex can be improved. Therefore, 1,3-divinyl-1,1,3,3-tetramethyldisiloxane, 1,3-diallyl-1,1,3,3-tetramethyldisiloxane, 1,3-divinyl-1,3-dimethyl-1,3-diphenyldisiloxane, 1,3-divinyl-1,1,3,3-tetraphenyldisiloxane, and 1,3,5,7-tetramethyl-1,3,5,7-tetravinylcyclotetrasiloxane, or other alkenylsiloxane or dimethylsiloxane oligomers or other organosiloxane oligomers are preferably added to the complex, with an alkenylsiloxane particularly preferably added to the complex. In addition, from the perspective of improving handling workability and pot life of the composition, these hydrosilylation reaction catalysts may be thermoplastic resin fine particles containing a hydrosilylation reaction catalyst, which are catalysts dispersed or encapsulated in a thermoplastic resin such as a silicone resin, a polycarbonate resin, an acrylic resin, or the like, and particularly may be thermoplastic resin fine particles containing a hydrosilylation reaction catalyst that contains platinum. It should be noted that as the catalyst for promoting the hydrosilylation reaction, a non-platinum-based metal catalyst such as iron, ruthenium, iron/cobalt, or the like may be used.

In particular, when the composition according to the present invention is a composition that forms an electrode upon curing, at least a portion of component (D) is (D1) thermoplastic resin fine particles containing a platinum-containing hydrosilylation reaction catalyst, from the perspective of improving the stability during production of the hot-melt composition, handling ease, and pot life of the composition. The thermoplastic fine particles may be either fine particles in which a platinum-based hydrosilylation reaction catalyst is dissolved or dispersed in a thermoplastic resin, or microcapsule fine particles having a structure in which a platinum-based catalyst is contained as a nucleus within a shell of a thermoplastic resin. Examples of platinum catalysts include the alkenylsiloxane complexes of platinum as described above. Furthermore, the thermoplastic resin is not particularly limited so long as the platinum-based catalyst does not substantially permeate at least during production and storage of the present composition and is not substantially soluble in a main component organopolysiloxane of the present composition. However, the softening point or glass transition point of the thermoplastic resin is preferably 80°C or higher, and more preferably 120°C or higher. Specifically, a silicone resin, a polysilane resin, an epoxy resin, an acrylic resin, and a methyl cellulose polycarbonate resin can be suitably used. The softening point is the temperature at which a resin begins to flow under its own weight or by its own surface tension, and can be measured by a method of observing pulverized particles under a microscope while increasing the temperature at a constant rate. Furthermore, the glass transition point can be measured by a DSC (differential scanning calorimeter). In the present invention, either the softening point or the glass transition point is preferably 120°C or higher. This is because if the softening point or glass transition point of the thermoplastic resin is less than 120°C, there is a concern that the platinum component will begin to elute during the homogeneous mixing step of the present composition, which is described later. Furthermore, the average particle size of the thermoplastic fine particles containing the platinum-based catalyst is not limited, but is preferably in the range of 0.1 to 500 µm, and more preferably in the range of 0.3 to 100 µm. This is because preparing thermoplastic resin fine particles containing a platinum-based catalyst with an average particle size that is less than the lower limit of the range above is difficult. On the other hand, dispersibility in the composition is reduced if the average particle size exceeds the upper limit of the range above.

The method for preparing the thermoplastic resin fine particles containing the hydrosilylation reaction catalyst containing platinum is not limited, and examples include conventionally known chemical methods such as interfacial polymerization, in-situ polymerization, and the like, and physical and mechanical methods such as coacervation, drying in liquid, and the like. The drying in liquid method and vapor phase drying method using a spray dryer or the like are particularly desirable because obtaining microcapsule fine particles with a narrow particle size distribution is relatively easy. The fine particles obtained by these methods can be used as is, but it is desirable to wash the fine particles with an appropriate cleaning solvent to remove the platinum-based catalyst attached to the surface, in order to obtain a composition with excellent storage stability. Herein, an appropriate cleaning solvent does not dissolve the thermoplastic resin, but has a property of dissolving the platinum-based catalyst. Examples of such cleaning solvents include methyl alcohol, ethyl alcohol, and other alcohols, hexamethyldisiloxane and other low molecular weight organopolysiloxanes, and the like. The ratio of hydrosilylation reaction catalyst to thermoplastic resin is not particularly limited, because the value varies greatly depending on the method for manufacturing a granular product, but the ratio is preferably such that the amount of platinum-based catalyst to thermoplastic resin is 0.01 mass% or more. This is because if the amount of platinum-based catalyst is less than 0.01 mass%, the physical properties of the cured product of the present composition will be impaired unless a large amount of thermoplastic resin fine particles containing the platinum-based catalyst is included in the present composition.

The added amount of hydrosilylation-reaction catalyst which is component (D) is preferably an amount such that the metal atoms are within a range of 0.01 to 500 ppm, 0.01 to 100 ppm, or 0.01 to 50 ppm by mass with respect to the entire composition.

Furthermore, a portion or all of component (D) is a hydrosilylation reaction catalyst which does not exhibit activity without irradiation with a high energy beam, but exhibits activity in the composition by irradiation with a high energy beam, or is a so-called high energy beam activation catalyst or photoactivation catalyst. By using such a component (D), the composition as a whole can be cured even at low temperatures triggered by irradiation with a high energy beam, has excellent storage stability, and facilitates reaction control; thus, the properties of excellent handling workability can be achieved.

Examples of high energy beams include UV rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm² to 100 J/cm².

Specific examples of component (D) include (methylcyclopentadienyl) trimethyl platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4- pentanedionato) platinum (II), bis(2,4-hexanedionato) platinum (II), bis(2,4-heptanedionato) platinum (II), bis(3,5-heptanedionato) platinum (II), bis(1 -phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

The amount of the high energy ray activation catalyst component (D) used is an effective amount and is not particularly limited so long as the amount promotes curing of the composition of the present invention. Specifically, the amount of metal atoms in the catalyst is 0.01 to 1,000 ppm by mass relative to the sum of components (A) to (C) (the total being 100 mass%), and preferably the amount of platinum metal atoms in component (D) is within the range of 0.1 to 500 ppm.

### (Component (E))

Component (E) is conductive fine particles, which are not particularly limited as long as they can impart conductivity to an electrode layer formed using the hot-melt composition of the present invention. It should be noted that an electrode layer containing conductive fine particles has been proposed, for example, in International Patent Publication WO2014/105959 by the present applicants, but there is no disclosure of a hot-melt composition or carbon nanotubes (CNT) in particular.

Specific examples of Component (E) include: electrically conductive carbon such as carbon nanotubes (CNT), conductive carbon black, graphite (including graphite coated with a conductive material such as a metal, such as nickel graphite, in the present invention), gas phase-grown mono-length carbon (VGCF), or the like; and metal powders such as platinum, gold, silver, copper, nickel, tin, zinc, iron, aluminum, or the like powders; as well as coated pigments such as antimony-doped tin oxide, phosphorous-doped tin oxide, needle-shaped titanium oxide surface treated using tin/antimony oxide, tin oxide, indium oxide, antimony oxide, zinc antimonate, carbon, and graphite or carbon whiskers surface treated by tin oxide or the like; pigments coated by at least one type of electrically conductive oxide such as tin-doped indium oxide (ITO), fluorine-doped tin oxide (FTO), phosphorous-doped tin oxide, and phosphorous-doped nickel oxide; and pigments having electrical conductivity and containing tin oxide and phosphorous in the surface of titanium oxide particles; these electrically conductive inorganic particles being optionally surface treated using various types of the below described surface treatment agents. These may be used independently or two or more may be used in combination. Furthermore, in order to disperse uniformly in the composition, the conductive fine particles may be kneaded in advance with a portion or all of components (A) to (C) used in the composition, and then blended in the composition in the form of a compound.

Furthermore, the conductive inorganic fine particles may be obtained by coating a conductive material such as a metal or the like on the surface of fibers such as glass fibers, silica alumina fibers, alumina fibers, carbon fibers, and the like, needle shaped reinforcing materials such as aluminum borate whiskers, potassium titanate whiskers, and the like, or inorganic filling materials such as glass beads, talc, mica, graphite, wollastonite, dolomite, and the like.

In the hot-melt electrode layer-forming organopolysiloxane composition of the present invention, at least a portion of component (E) is preferably fine particles containing at least one type of conductive carbon selected from carbon nanotubes (CNT), conductive carbon black, graphite, and vapor grown carbon (VGCF), regardless of being curable or not. These conductive fine particles have excellent uniform dispersibility in the organopolysiloxane composition, and have the advantages of imparting excellent temperature dependency to the viscoelasticity of the electrode layer obtained using the hot-melt composition, as well as effectively improving the conformability and shape retention of the electrode layer relative to the dielectric layer.

In the hot-melt electrode layer-forming organopolysiloxane composition of the present invention, at least a portion or all of component (E) is carbon nanotubes (CNT). The CNT may be single-walled, double-walled, or multi-walled, and the particle size is not particularly limited, but conductive fine particles containing (E1) single-walled carbon nanotubes (SWCNT) are particularly preferred.

Single-walled carbon nanotubes (SWCNT) are a special type of carbon material known as a one-dimensional material. Single-walled carbon nanotubes include sheets of graphene rolled up to form hollow tubes with walls one atom thick. Due to their chemical structure and size, single-walled carbon nanotubes tend to exhibit particularly excellent mechanical, electrical, thermal and optical properties, even as compared to other conductive carbons such as acetylene black. In particular, they can effectively reduce the volume resistivity of the electrode layer obtained even when used in small amounts, and can achieve excellent temperature dependency of the viscoelasticity without impairing the mechanical strength of the electrode layer, such as the elongation at break and tensile strength. This provides the advantage that, in addition to improving the performance and strength of the electrode layer, including improving the energy density, the conformability and shape retention of the electrode layer relative to the dielectric layer can be effectively improved.

The average outer diameter of the single-walled carbon nanotubes is not particularly limited, but is preferably 2.5 nm or less. More preferably, the average outer diameter is from 1.0 to 2.5 nm, more preferably from 1.1 to 2.0 nm, and particularly preferably from 1.2 to 1.8 nm. The average outer diameter of the single-walled carbon nanotubes can be determined from the optical absorption spectrum of the single-walled carbon nanotubes obtained by ultraviolet-visible-near infrared spectroscopy (UV-Vis-NIR), Raman spectroscopy, or transmission electron microscope (TEM) imaging.

The average fiber length of the single-walled carbon nanotubes is preferably less than 100 µm. The thickness of the single-walled carbon nanotubes is more preferably 0.1 to 50 µm, more preferably 0.5 to 20 µm, and particularly preferably 1 to 10 µm. The average fiber length of the single-walled carbon nanotubes can be determined by obtaining an AFM image of the single-walled carbon nanotubes using an atomic force microscope (AFM) or obtaining a TEM image of the single-walled carbon nanotubes using a transmission electron microscope (TEM), measuring the length of all single-walled carbon nanotubes, and dividing the total length by the number of single-walled carbon nanotubes measured.

The G/D ratio of the single-walled carbon nanotubes measured by Raman spectroscopy (wavelength 532 nm) is preferably 2 or more. The G/D ratio is more preferably 2 to 250, even more preferably 5 to 250, particularly preferably 10 to 220, and most preferably 40 to 180. The G/D ratio is the intensity ratio (G/D) of the G band to the D band in the Raman spectrum of the single-walled carbon nanotube. A higher value for the G/D ratio of the single-walled carbon nanotube indicates higher crystallinity of the single-walled carbon nanotube, as well as fewer carbon impurities and defective carbon nanotubes.

Single-walled carbon nanotubes (SWCNT) are commercially available products. In the present invention, examples include TUBALL(TM) MATRIX 601 (polydimethylsiloxane containing 10 mass% of single-walled carbon nanotubes), TUBALL(TM) MATRIX 602 (vinyl ether-terminated polydimethylsiloxane containing 10 mass% of single-walled carbon nanotubes), TUBALL(TM) MATRIX 201 (fatty acid glycidyl ester containing 10 mass% of single-walled carbon nanotubes), TUBALL(TM) MATRIX 202 (aliphatic carboxylate derivative containing 10 mass% of single-walled carbon nanotubes), TUBALL(TM) MATRIX 204 (methacrylic acid ester derivative containing 10 mass% of single-walled carbon nanotubes), and TUBALL(TM) MATRIX 301 (ethoxylated alcohol containing 10 mass% of single-walled carbon nanotubes) (all manufactured by Kusumoto Chemicals Co., Ltd.).

The conductive fine particles may have surfaces that are partially or entirely treated with an organosilicon compound. Examples of organic silicon compounds include: low molecular weight organic silicon compounds such as silanes, silazanes, siloxanes, and the like; and organic silicon polymers or oligomers such as polysiloxanes, polycarbosiloxanes, and the like. A so-called silane coupling agent is an example of a preferred silane. Typical examples of silane coupling agents include alkyltrialkoxysilanes (such as methyltrimethoxysilane, vinyltrimethoxysilane, hexyltrimethoxysilane, octyltrimethoxysilane, and the like) and trialkoxysilanes containing an organic functional group (such as glycidoxypropyltrimethoxysilane, epoxycyclohexyl ethyltrimethoxysilane, methacryloxypropyltrimethoxysilane, aminopropyltrimethoxysilane, and the like). Examples of preferred siloxanes and polysiloxanes include hexamethyldisiloxanes, 1,3-dihexyl-tetramethyldisiloxanes, trialkoxysilyl single-terminated polydimethylsiloxanes, trialkoxysilyl single-terminated dimethylvinyl single-terminated polydimethylsiloxanes, trialkoxysilyl single-terminated organic functional group single-terminated polydimethylsiloxanes, trialkoxysilyl doubly-terminated polydimethylsiloxanes, organic functional group doubly-terminated polydimethylsiloxanes, and the like. When a siloxane is used, the number "n" of siloxane bonds is preferably within the range of 2 to 150. Furthermore, the siloxane does not necessarily have to be in the main chain, and organic polymers modified with siloxane may also be used, such as silicone-modified acrylic polymers. Examples of preferred silazanes include hexamethyldisilazanes, 1,3-dihexyl-tetramethyldisilazanes, and the like. A polymer having a Si-C-C-Si bond in a polymer main chain is an example of a preferred polycarbosiloxane.

The amount of component (E) added can be appropriately designed depending on the electrical conductivity (in other words, volume resistivity), mechanical strength, shape retention, and the like of the resulting electrode layer. In practice, however, the amount of component (E) conductive fine particles is preferably in a range of 0.005 to 0.50, and more preferably 0.005 to 0.25, based on the volume fraction of the entire composition. Within this range of the added amount of component (E), the volume resistivity of the electrode layer obtained using the present composition is 10² Ω·cm or less, preferably in a range of 10 to 10² Ω·cm, which is advantageous in that an electrode layer exhibiting excellent conductivity can be designed. In particular, when a portion of component (E) is fine particles containing conductive carbon, particularly when a portion of component (E) is single-walled carbon nanotubes (SWCNT), there is an advantage that the volume resistivity of the electrode layer will be effectively reduced to achieve excellent conductivity, and excellent temperature dependency of the viscoelasticity can be achieved without impairing the mechanical strength of the electrode layer, such as the elongation at break and the tensile strength. In particular, the volume fraction of the single-walled carbon nanotubes (SWCNT) relative to the entire composition is preferably in a range of 0.005 to 0.25.

The present composition may contain other optional components, such as (F) a reinforcing filler, (G) a cure retarding agent, (H) an adhesion promoter, and (I) an organic wax, so long as the object of the present invention is not impaired. It should be noted that as described below, the present composition may contain an organic solvent, but is preferably a substantially solvent-free hot-melt composition.

### [Component (F)]

Component (F) is a reinforcing filler, which may improve the mechanical strength of an electrode layer obtained using the present composition. Specifically, the reinforcing fine particles are preferably one or more types of reinforcing inorganic fine particles having an average primary particle size of less than 50 nm. Examples include fumed silica, wet silica, pulverized silica, calcium carbonate, diatomaceous earth, finely pulverized quartz, various metal oxide powders other than alumina and zinc oxides, glass fibers, carbon fibers, and the like, and those treated with one or more types of organic silicon compounds described below are used. The shape thereof is not particularly limited, with arbitrary shapes including a particle shape, plate shape, needle shape, fibrous shape, and the like capable of being used.

A preferred example of component (F) is hydrophilic or hydrophobic fumed silica or a metal oxide complex thereof, which has an average primary particle size of 10 nm or less, which may be partially aggregated. Furthermore, from the viewpoint of improving dispersibility, fumed silica or a metal oxide complex thereof which has been treated with the aforementioned organosilicon compound is preferred. Two or more types of the reinforcing inorganic particles may be used in combination.

The BET specific surface area of component (F) can be appropriately selected, but may be 10 m²/g or more, and may be in a range of 10 to 1000 m²/g. Furthermore, as component (F), two or more types of reinforcing fillers having different BET specific surface areas may be used in combination. Examples include (F1) reinforcing fine particles or composites thereof which have been surface-treated with one or more organosilicon compounds with an average BET specific surface area of more than 100 m²/g, and (F2) reinforcing fine particles or composites thereof which have been surface-treated with one or more organosilicon compounds with an average BET specific surface area in a range of 10 to 100 m²/g, either of which may be used alone as component (F), or components (F1) and (F2) may be used in combination in any mass ratio.

Component (F) is preferably surface-treated with the aforementioned organosilicon compound, and suitable organosilicon compounds include one or more selected from the group consisting of hexamethyldisilazane and 1,3-bis(3,3,3-trifluoropropyl)-1,1,3,3-tetramethyldisilazane. It should be noted that a surface treatment using a surface treating agent other than an organic silicon compound may be used in combination, within a scope that does not impair the technical effects of the present invention.

The amount of the surface treating agent with regard to the total amount of the filler in the surface treatment is preferably within a range of 0.1 mass% or more and 50 mass% or less, and more preferably within a range of 0.3 mass% or more and 40 mass% or less. It should be noted that the treatment amount is preferably proportional to the added amount of fillers to the surface treating agent, with excess treating agent preferably removed after treatment. Furthermore, there is no problem in using additives and the like that promote or assist a reaction when treating if necessary.

### [Component (G)]

Component (G) is a curing retarding agent, which may effectively suppress side reactions, particularly when the present composition is cured by a hydrosilylation reaction, and may further improve the storage stability of the composition according to the present invention, the usable time when heated and melted, and the like.

The available cure retardants are not limited in terms of structure or type and can be selected from among known hydrosilylation reaction inhibitors. Examples include 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl propynyloxy)silane, vinyl tris(1,1-dimethyl propynyloxy)silane, and other alkynyloxysilanes. It should be noted that if the present composition is produced by a process involving heating, such as melt kneading, a compound having a boiling point of 200°C or higher at atmospheric pressure may be used as component (G).

A compound with a boiling point of 200°C or higher under atmospheric pressure is particularly preferably used as component (G). This is because, from the standpoint of compositional uniformity, if a compound with a low boiling point is used as a delayed curing agent in the composition of the present invention, a portion or all of the cure retarding agent will volatilize during processes such as melt kneading, and there is a risk that the targeted cure retardation effect in the final curable silicone composition will not be obtained. It should be noted that methyl-tris (1, 1-dimethyl-2-propynyloxy) silane has a boiling point of approximately 293°C under atmospheric pressure and is one example of a suitable component (G).

The amount of component (G) used is arbitrary, but is preferably in the range of 1 to 10000 ppm in mass units with respect to the entire composition.

### [Component (H)]

Component (H) is an adhesion imparting agent, and examples include organic silicon compounds having at least one alkoxy group bonded to a silicon atom in one molecule. Examples of the alkoxy group include methoxy groups, ethoxy groups, propoxy groups, butoxy groups, and methoxyethoxy groups, with methoxy groups being particularly preferable. Furthermore, examples of groups bonded to a silicon atom other than the alkoxy groups in the organic silicon compound include: halogen-substituted or unsubstituted monovalent hydrocarbon groups such as alkyl groups, alkenyl groups, aryl groups, aralkyl groups, halogenated alkyl groups, and the like; glycidoxyalkyl groups such as 3-glycidoxypropyl groups, 4-glycidoxybutyl groups, and the like; epoxycyclohexylalkyl groups such as 2-(3,4-epoxycyclohexyl)ethyl groups, 3-(3,4-epoxycyclohexyl)propyl groups, and the like; epoxyalkyl groups such as 3,4-epoxybutyl groups, 7,8-epoxyoctyl groups, and the like; acrylic group-containing monovalent organic groups such as 3-methacryloxypropyl groups and the like; and hydrogen atoms. This organic silicon compound preferably has a group that may react with an alkenyl group or a silicon atom-bonded hydrogen atom in the present composition, and specifically, preferably has a silicon atom-bonded hydrogen atom or an alkenyl group. Furthermore, favorable adhesion can be imparted to various base materials, and thus this organic silicon compound preferably has at least one epoxy group-containing monovalent organic group in one molecule. Examples of such organic silicon compounds include organosilane compounds, organosiloxane oligomers, and alkyl silicates. Examples of molecular structures of this organosiloxane oligomer or alkyl silicate include linear structures, partially branched linear structures, branched structures, cyclic structures, and network structures, of which linear structures, branched structures, and network structures are particularly preferable. Examples of the organic silicon compound include: silane compounds such as 3-glycidoxypropyltrimethoxysilane, 2-(3,4-epoxycyclohexyl) ethyltrimethoxysilane, 3-methacryloxypropyltrimethoxysilane, and the like; siloxane compounds having at least one silicon atom-bonded alkenyl group or silicon atom-bonded hydrogen atom and one silicon atom-bonded alkoxy group in one molecule; mixtures of a silane compound or siloxane compound having at least one silicon atom-bonded alkoxy group and a siloxane compound having at least one silicon atom-bonded hydroxy group and one silicon atom-bonded alkenyl group in one molecule; reaction mixtures of amino group-containing organoalkoxysilane and epoxy group-containing organoalkoxysilane; organic compounds having at least two alkoxysilyl groups in one molecule and containing bonds other than a silicon-oxygen bond between these silyl groups; epoxy group-containing silanes expressed by the general formula:

R^{a}ₙSi(OR^{b})₄₋ₙ

(wherein, R^{a} represents an organic group containing a monovalent epoxy group, while R^{b} represents an alkyl group having from 1 to 6 carbon atoms, or a hydrogen atom. n represents a number within the range of 1 to 3),
or a partially hydrolyzed condensate thereof; reaction mixtures of a vinyl group-containing siloxane oligomer (including those with chain or cyclic structures) and an epoxy group-containing trialkoxysilane; methyl polysilicates; ethyl polysilicates; and epoxy group-containing ethyl polysilicates. The adhesion imparting agent is preferably in the form of a low viscosity liquid, and the viscosity thereof is not limited, but is preferably within the range of 1 to 500 mPa·s at 25°C. Furthermore, while not limited thereto, the amount of the adhesion imparting agent is preferably within the range of 0.01 to 10 parts by mass with respect to a total of 100 parts by mass of the present composition.

In the present invention, a reaction mixture of an organoalkoxysilane containing an amino group and an organoalkoxysilane containing an epoxy group is an example of a particularly preferable adhesion imparting agent. These components improve the initial adhesion to various base materials with which the composition comes into contact during the formation of the electrode layer obtained using the composition (after heat melting and during curing), and in particular, low-temperature adhesion to unwashed adherends. Such a reaction mixture is disclosed in Japanese Examined Patent Publication 52-8854 and Japanese Unexamined Patent Application 10-195085.

Examples of alkoxysilanes having an amino group-containing organic group forming such component include an aminomethyltriethoxysilane, 3-aminopropyltrimethoxysilane, 3-aminopropyltriethoxysilane, 3-aminopropylmethyldimethoxysilane, N-(2-aminoethyl)aminomethyltributoxysilane, N-(2-aminoethyl)-3-aminopropyltrimethoxysilane, N-(2-aminoethyl)-3-aminopropylmethyldimethoxysilane, and 3-anilinopropyltriethoxysilane.

Furthermore, examples of epoxy group-containing organoalkoxysilanes include 3-glycidoxyprolyltrimethoxysilanes, 3-glycidoxypropylmethyldimethoxysilanes, 2-(3,4-epoxy cyclohexyl)ethyltrimethoxysilanes, and 2-(3,4-epoxy cyclohexyl)ethylmethyldimethoxysilanes.

The ratio of the alkoxysilane having an amino group-containing organic group to the alkoxysilane having an epoxy group-containing organic group is, in terms of molar ratio, preferably within the range of (1:1.5) to (1:5), and particularly preferably within the range of (1:2) to (1:4). This component can be easily synthesized by mixing an alkoxysilane having an amino group-containing organic group and alkoxysilane having an epoxy group-containing organic group as described above to cause a reaction at room temperature or by heating.

In particular, when an alkoxysilane having an amino group-containing organic group is reacted with an alkoxysilane having an epoxy group-containing organic group by the method described in Japanese Unexamined Patent Application Publication H10-195085, the composition of the present invention particularly preferably contains a carbasilatrane derivative obtained by cyclizing by an alcohol exchange reaction and expressed by the general formula: 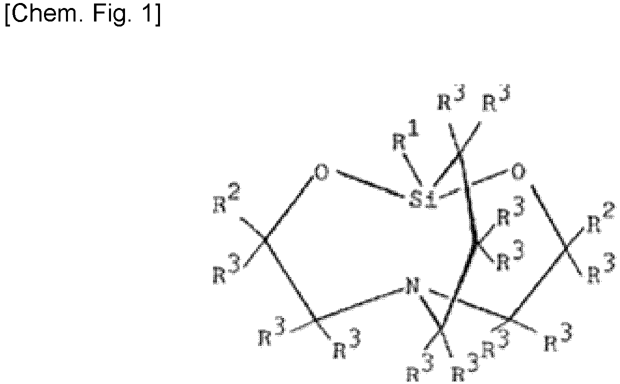 {where R¹ represents an alkyl group, an alkenyl group, or an alkoxy group, and R² represents the same or different groups selected from the group consisting of groups expressed by the general formula: 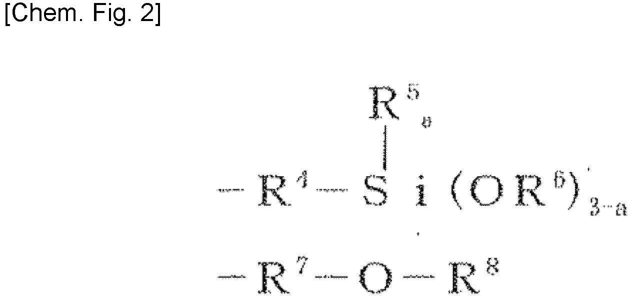 (where R⁴ represents an alkylene group or alkyleneoxyalkylene group, R⁵ represents a monovalent hydrocarbon group, R⁶ represents an alkyl group, R⁷ represents an alkylene group, R⁸ represents an alkyl group, alkenyl group, or acyl group, and "a" represents 0, 1, or 2.), and
R³ represents the same or different hydrogen atoms or alkyl groups}.

Examples of such carbasilatrane derivatives include carbasilatrane derivatives having a silicon atom-bonded alkoxy group or a silicon atom-bonded alkenyl group in one molecule expressed by the following structure: 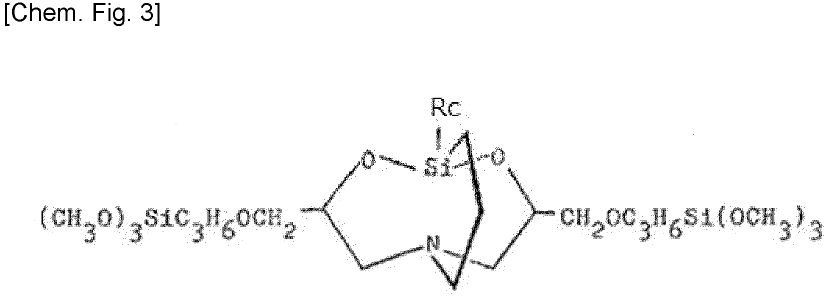 (where Rc represents a group selected from methoxy groups, ethoxy groups, vinyl groups, allyl groups, and hexenyl groups.)

Furthermore, in the present invention, a silatrane derivative expressed by the following structural formula may be used as the adhesion imparting agent.

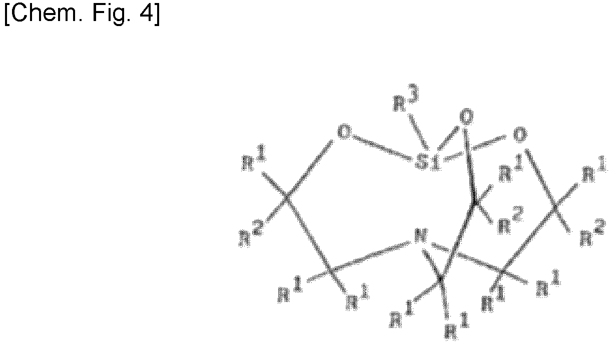

In the formula, R¹ represents the same or different hydrogen atom or alkyl group, with R¹ particularly preferably being a hydrogen atom or a methyl group. Furthermore, in the formula above, R² represents the same or different group selected from the group consisting of a hydrogen atom, an alkyl group, and an alkoxysilyl group-containing organic group expressed by general formula: -R⁴-Si(OR⁵)ₓR⁶₍₃₋ₓ₎, provided that at least one R² represents an alkoxysilyl group-containing organic group. Examples of alkyl groups R² include methyl groups and the like. Furthermore, in the alkoxysilyl group-containing organic group of R², R⁴ in the formula represents a divalent organic group. Examples thereof include alkylene groups and alkyleneoxyalkylene groups, with ethylene groups, propylene groups, butylene groups, methylene oxypropylene groups, and methylene oxypentylene groups being preferable. Furthermore, R⁵ in the formula represents an alkyl group having 1 to 10 carbon atoms, and preferably a methyl group or an ethyl group. Furthermore, R⁶ in the formula represents a substituted or unsubstituted monovalent hydrocarbon group, and preferably a methyl group. Furthermore, in the formula, x represents 1, 2, or 3, and preferably 3.

Examples of such alkoxysilyl group-containing organic groups of R² include the following groups:

-(CH₂)₂Si(OCH₃)₂(CH₂)₂Si(OCH₃)₂CH₃

-(CH₂)₃Si(OC₂H₅)₂(CH₂)₃Si(OC₂H₅)(CH₃)₂

-CH₂O(CH₂)₃Si(OCH₃)₃

-CH₂O(CH₂)₃Si(OC₂H₅)₃

-CH₂O(CH₂)₃Si(OCH₃)₂CH₃

-CH₂O(CH₂)₃Si(OC₂H₅)₂CH₃

-CH₂OCH₂Si(OCH₃)₂CH₂OCH₂Si(OCH₃)(CH₃)₂

R³ in the formula above represents at least one group selected from the group consisting of substituted or unsubstituted monovalent hydrocarbon groups, alkoxy groups having 1 to 10 carbon atoms, glycidoxyalkyl groups, oxiranylalkyl groups, and acyloxyalkyl groups. Examples of monovalent hydrocarbon groups of R³ include alkyl groups such as methyl groups and the like. Examples of alkoxy groups of R³ include methoxy groups, ethoxy groups, propoxy group, and the like. Examples of glycidoxypropyl groups of R³ include 3-glycidoxypropyl groups and the like. Examples of oxiranylalkyl groups of R³ include 4-oxiranylbutyl groups, 8-oxiraniloctyl groups, and the like. Examples of acyloxyalkyl groups of R³ include acetoxypropyl groups, 3-methacryloxypropyl groups, and the like. In particular, R³ preferably represents an alkyl group, an alkenyl group, or an alkoxy group, and more preferably an alkyl group or an alkenyl group, and particularly preferred examples thereof include groups selected from methyl groups, vinyl groups, allyl groups, and hexenyl groups.

The amount of component (H) used is not particularly limited, but from the perspective of improving adhesion to the dielectric layer or the like, the amount is preferably in the range of 0.1 to 1.0 mass% of the total composition, with 0.2 to 1.0 mass% being more preferred.

### [Component (I)]

Component (I) is an organic wax, specifically, an organic wax having a melting point within a range of 30 to 160°C. One or more types selected from among hot-melt synthetic resins, waxes, fatty acid metal salts, and the like are examples of component (I). The wax component exhibits low kinematic viscosity at high temperatures (150°C) and forms a melt with excellent fluidity. Furthermore, by combining components (A), (B), and (E) as described above, the wax component in the melt containing the present composition spreads quickly throughout the composition at high temperatures, thereby lowering the viscosity of the base material surface to which the molten composition is applied and of the composition as a whole, rapidly lowering the surface friction of the base material and the molten composition and significantly increasing the fluidity of the composition as a whole. Therefore, there are cases where the viscosity and fluidity of the molten composition can be greatly improved by adding only a very small amount to the total amount of other components.

Component (I) may be paraffin or other petroleum waxes, carnaba wax and other natural waxes, or montanate ester wax and other synthetic waxes, so long as the wax components satisfy the aforementioned conditions of dropping point and kinematic viscosity when melted. However, from the perspective of the technical effect of the present invention, the wax component is preferably a hot-melt component containing a fatty acid metal salt or an erythritol derivative fatty acid ester, and particularly preferably metal salts of higher fatty acids such as stearic acid, palmitic acid, oleic acid, isononanoic acid and the like, or pentaerythritol tetrastearate, dipentaerythritol adipic acid stearate, glycerintri-18-hydroxystearate, or pentaerythritol fulstearate. Herein, the types of fatty acid metal salts described above are also not particularly limited, and preferable examples include: alkali metal salts such as lithium, sodium, potassium, and the like; alkali earth metal salts such as magnesium, calcium, barium, and the like; and zinc salts.

With regard to the amount of Component (I) used, assuming that the overall composition is 100 parts by mass, the amount of the component is in the range of 0.01 to 5.0 parts by mass and may be 0.01 to 3.5 parts by mass or 0.01 to 3.0 parts by mass. If the amount of the wax component used exceeds the upper limit described above, the adhesive properties and mechanical strength of the electrode layer obtained from the composition of the present invention may be insufficient. Furthermore, if the amount used is less than the lower limit described above, sufficient fluidity while heating and melting may not be achieved.

### [Use of Solvent]

The hot-melt electrode layer-forming organopolysiloxane composition of the present invention is non-fluid (solid or semi-solid) at 25°C and is heat meltable, so the use of a solvent is substantially unnecessary and a solvent-free design is possible. In addition, no fluorine-based solvents, organic solvents, and the like remain in the film obtained after curing, which has the advantages of eliminating environmental load problems and the effects of solvents on electronic devices. However, this does not preclude the use of organic solvents which are inevitably mixed into the raw materials of the composition of the present invention, or small amounts of organic solvents, from the viewpoint of handling. Specifically, the composition of the present invention may be, and is preferably, a low-solvent to solvent-free composition containing an organic solvent in an amount of 5 parts by mass or less, preferably 1 part by mass or less, and more preferably below the detection limit, relative to the sum (100 parts by mass) of components (A), (B), and (E). It should be noted that examples of the solvent include one or more organic solvents selected from (S1) organic polar solvents, (S2) low molecular weight siloxane-based solvents, and (S3) halogen-based solvents, or mixed solvents thereof, and in particular, solvents having a boiling point of 80°C or higher and lower than 200°C can be exemplified.

The hot-melt electrode layer-forming organopolysiloxane composition of the present invention is most preferably in the form of a solvent-free composition where the amount of the organic solvent is 1 part by mass or less, or the detection limit or less, and thus the composition is substantially free of organic solvent.

Furthermore, the present composition may contain, as other optional components: iron oxide (red iron oxide), cerium oxide, cerium dimethylsilanolate, fatty acid cerium salts, cerium hydroxide, zirconium compounds, and other heat-resistant agents, dyes, non-white pigments, flame retardancy-imparting agents, aluminum hydroxide, magnesium hydroxide, zinc borate, zinc molybdate, phosphazene, and other heat reducers, hydrotalcite, bismuth oxides, yttrium oxides, and other ion scavengers and pH adjusters, aluminum hydroxide, magnesium hydroxide, zinc borate, zinc molybdate, phosphazene, and other flame retardants, hindered phenol compounds, hindered amine compounds, thioether compounds, and other antioxidants, pure iron, silicon steel, iron-cobalt alloy, iron-nickel alloy, iron-chromium alloy, iron-aluminum alloy, carbonyl iron, stainless steel, composite materials containing one or more thereof, and other soft magnetic particles, inorganic flame retardants (such as aluminum hydroxide and other hydrated metal compounds), halogenated flame retardants, phosphorus-based flame retardants, organometallic salt-based flame retardants, silicone oil, silicone rubber, polyisoprene, 1,2-polybutadiene, 1,4-polybutadiene, and other polybutadienes, styrene-butadiene rubber, acrylonitrile-butadiene rubber, butadiene acrylonitrile rubber blocked with a carboxyl group at an end, polychloroprene, poly(oxypropylene), poly(oxytetramethylene) glycol, polyolefin glycol, poly-ε-caprolactone, and other thermoplastic elastomers, polysulfide rubber, fluoroelastomer, and other stress reducing agents, barium titanate (BaTiO₃), strontium titanate (SrTiO₃), lead zirconate titanate (Pb(Zr, Ti)O₃, PZT), alumina (Al₂O₃, aluminum oxide), zirconia (ZrO₂, zirconium dioxide), magnesia (MgO, magnesium oxide), silica (SiO₂, silicon dioxide), titania (TiO₂, titanium dioxide), aluminum nitride (AIN), silicon nitride (Si₃N₄), silicon carbide (SiC), Barium calcium titanate zirconate (BCTZ), polyvinylidene fluoride, and other dielectric ceramics, copper chloride, cuprous iodide, copper acetate, cerium stearate, and other metal salt stabilizers, hindered amine-based organic compounds, hindered phenol-based organic compounds, sulfur-containing compound-based organic compounds, acrylate-based organic compounds, and phosphorus-based organic compounds, and other antioxidants and heat stabilizers; benzophenones, salicylates, benzotriazoles, and other UV absorbers, weathering agents, light stabilizers, and the like, so long as the object of the present invention is not impaired.

### [Use of the composition: formation of electrode layer]

The form of the present composition is not particularly limited, and depending on the production process, any of the following forms are possible, namely block, solid to semi-solid wax, grains, granules, pellets (tablet), or sheets. Furthermore, the composition in the form of a block, solid to semi-solid paste, granules, or granular composition may be tableted by a known method in order to be used in the form of a pellet or tablet. Similarly, the raw materials may be melt-kneaded using a single-screw or multi-screw (twin-screw or the like) extruder, and the extruded molten mixture may be laminated between a release film having a known release layer such as fluorosilicone to obtain a sheet-like molded product. Alternatively, the molten mixture may be directly molded into the shape of pellets/tablets depending on the shape of the extrusion port. In particular, the composition itself is non-fluid to solid, so the composition has the advantages of excellent handling properties and storage stability.

The present composition has hot-melt properties, flows quickly when heated and melted, and can be applied uniformly to desired locations. Furthermore, an electrode layer can be formed by cooling and an optional curing process. Therefore, the composition can be used without restriction in solvent-free processes and electrode printing processes, aimed at reducing the environmental load and improving the performance of actuators, and the like. Furthermore, the present composition has excellent formability, gap-filling properties, and adhesive strength when heated and melted, and the electrode layer obtained has excellent heat resistance, durability, adhesion, and temperature dependency of the viscoelastic properties. Therefore, when an electrode layer made of the present composition is formed on a dielectric elastomer sheet, the electrode layer has remarkably excellent conformability and shape retention, and even when used in a transducer that assumes a high degree of physical displacement, such as an actuator, the electrode layer is unlikely to peel off or have defects, and has viscoelastic properties sufficient for practical use.

The present composition can be used by heating and melting in order to be applied to a location where an electrode layer is to be formed. Specifically, the composition may be heated to 80°C or higher, melted, and then applied to the location where the electrode layer is to be formed by hot dispensing or the like; alternatively, a sheet-like molded product may be placed in a location where the electrode layer is to be formed and then heated to 80°C or higher, and thus the liquefied composition may be applied to the relevant location. It should be noted that the heat-melting temperature is not particularly limited as long as sufficient fluidity, coatability, and gap-filling properties can be achieved, but may be in a range of 80 to 150°C. If the composition has curing reactivity, the heat-melting temperature is preferably selected depending on the type of component (D). For example, if component (D) is a thermoplastic resin fine particle containing a platinum-containing hydrosilylation reaction catalyst using a thermoplastic resin with a softening point or glass transition point of 120°C, the hydrosilylation reaction activity is suppressed in the temperature range of 80 to 120°C, and therefore, within this temperature range, there is an advantage that the composition can be applied to the location where an electrode layer is desired by heating and melting without causing an unintended curing reaction.

The present composition can be applied to a location where an electrode layer is to be formed, and then, depending on whether the composition is curable or not, can be solidified by cooling or undergoing a curing reaction to form an electrode layer. **It** should be noted that depending on the type of component (D), the curing reaction may be carried out simultaneously with the application of the present composition by performing a heat curing reaction or high energy beam irradiation, simultaneous with heat melting.

The composition may be in a substantially solvent-free form, regardless of whether the composition has curing reactivity or not, and can be applied to the location where an electrode layer is to be formed after heating and melting (including application by heating and melting after placement at the location where the electrode layer is to be formed, in the case of a molded product such as a sheet), and then dried and solidified by cooling to form an electrode layer. In particular, the present composition has the advantage that even if the composition is in the form of an uncured or non-curing composition, the composition can be dried to form an electrode layer with excellent temperature dependency of viscoelastic properties, and thus the composition can be used as an electrode layer regardless of whether or not a curing reaction occurs, so flexible process design including solvent-free processes is possible.

If the present composition is designed as a curing-reactive composition, the composition can be applied to the location where an electrode layer is to be formed after heating and melting (including application by heating and melting after placement at the location where the electrode layer is to be formed, in the case of a molded product such as a sheet), and a curing reaction can be allowed to proceed simultaneous with or after application, thereby forming an electrode layer made of a cured product. When components (C) and (D) are used, the curing reaction is a hydrosilylation reaction, and depending on the type of component (D), a heat curing reaction, a curing reaction by irradiation with a high-energy beam, or a combination thereof can be selected.

The heat curing reaction temperature is not particularly limited, but is preferably 50°C or higher and 200°C or lower, more preferably 60°C or higher and 200°C or lower, and even more preferably 80°C or higher and 180°C or lower. Furthermore, the time required for the curing reaction is usually from 1 second to 3 hours. Generally, the cured product can be obtained by being maintained at a temperature within a range of 90 to 180°C for 10 seconds to 30 minutes. It should be noted that, as described above, when thermoplastic resin fine particles containing a platinum-containing hydrosilylation reaction catalyst and using a thermoplastic resin having a specific softening point or glass transition point are selected as component (D), the curing reaction does not proceed at temperatures below the softening point or glass transition point of the thermoplastic resin (wall material), but proceeds rapidly by heating at a temperature higher than that temperature. This has the advantage that the curing reaction can be easily controlled by temperature.

When at least a portion of component (D) is the aforementioned high-energy beam-activated catalyst, the curing reaction of the present composition proceeds when triggered by irradiation with a high-energy beam. Examples of active energy rays that may be used in the curing reaction include ultraviolet rays, electron beams, radiation, and the like. Ultraviolet rays are preferable in terms of practicality. If the curing reaction is performed using ultraviolet rays, a catalyst for the hydrosilylation reaction having high activity to ultraviolet rays is used, for example, a bis(2,4-pentanedionato)platinum complex or a (methylcyclopentadienyl)trimethylplatinum complex is preferably added. The ultraviolet ray generating source is preferably a high pressure mercury lamp, a medium pressure mercury lamp, an Xe-Hg lamp, a deep UV lamp, or the like. The irradiation amount in this case is preferably 100 to 8,000 mJ/cm².

The thickness and shape of the electrode layer can be appropriately designed as desired, but if the electrode layer has the aforementioned volume resistivity (conductivity), the form is that of a thin film, and the average thickness thereof may be preferably in a range of 1 to 100 µm.

The electrode layer obtained by the above curing reaction has excellent temperature dependency of the viscoelastic properties, and because the electrode layer is a cured product, the mechanical strength of the electrode layer itself, as well as adhesion and conformability to the base material, tend to be further improved. Furthermore, the use of an electrode layer that is a cured product has the advantage of having particularly excellent conformability and shape retention. In addition, the curing reaction is easy to control, so flexible process design including solvent-free processes is possible.

### [Use of the composition: laminate body and dielectric layer]

The electrode layer obtained using the present composition can be used in desired semiconductor members and electronic components, and can be used without particular restriction in electronic components such as semiconductor chips, electronic circuits, and semiconductor (including optical semiconductor) devices, and can form a laminate body including the electrode layer. In particular, an electrode layer obtained using the present composition will have excellent formability, gap-filling properties, and adhesive strength when heated and melted, and the electrode layer obtained has excellent heat resistance, durability, adhesion, and temperature dependency of the viscoelastic properties. Therefore, when an electrode layer made of the present composition is formed on a dielectric elastomer sheet, the electrode layer has remarkably excellent conformability and shape retention, and even when used in a transducer that assumes a high degree of physical displacement, such as an actuator, an electrode layer that is unlikely to peel off or have defects can be formed. It should be noted that the type of dielectric elastomer sheet is not particularly limited, but a dielectric layer which is a cured organopolysiloxane film is particularly preferred in terms of the mechanical strength, heat resistance, flexibility and electrochemical properties.

Specifically, the laminate body provided with an electrode layer obtained using the present composition is preferably a laminate body having a structure in which (L2) an electrode layer made of the aforementioned hot-melt electrode layer-forming organopolysiloxane composition is laminated on at least one surface of (L1) an organopolysiloxane cured film, which is a dielectric layer.

Organopolysiloxane cured products having a polysiloxane skeletal structure have excellent transparency, electrical insulation, heat resistance, cold resistance, and the like, can have improved electrical activity, if desired, by introducing a high dielectric functional group such as a fluoroalkyl group or the like, and can be easily processed into a film or sheet, and therefore can be used as a dielectric layer, particularly as an adhesive film used in various electric and electronic devices or as an electroactive film used in actuators and other transducer devices.

The curing mechanism of the organopolysiloxane cured film is classified into hydrosilylation reaction curing types, condensation reaction curing types, peroxide curing types, and the like, but an organopolysiloxane cured film using a curable organopolysiloxane composition of the hydrosilylation reaction curing type is particularly preferred because the film cures quickly when left at room temperature or when heated, and does not generate by-products.

The organopolysiloxane cured film which is the dielectric layer is a thin film, and the average thickness of the film is suitably within a range of 1 to 200 µm, preferably 1 to 150 µm, and more preferably 1 to 100 µm. Herein, the average thickness of the film is the average value of the thickness at the center of the film. Preferably, the organopolysiloxane cured film is uniform and flat, with the difference between the thickness at one end and the thickness at the center being within 5.0% in the width direction of the film. The average value of the thickness of the center of the film is more preferably within a range of 5 to 200 µm.

Similarly, when the number of internal defects in the organopolysiloxane cured film serving as the dielectric layer is measured by optical means within a unit area of 15 mm × 15 mm at any location, the number of internal defects is in a range of 0 to 20, and preferably in the range of 0 to 15. When the number of internal defects exceeds the aforementioned upper limit, dielectric breakdown is more likely to occur when a high voltage is applied on the film, and thus the dielectric breakdown strength of the entire film may be significantly reduced.

The organopolysiloxane cured film, which is the dielectric layer, has a dielectric breakdown strength measured at room temperature that is within a range of 56 V/µm to 200 V/µm, and more preferably 58 V/µm to 100 V/µm. Furthermore, the organopolysiloxane cured film of the present invention may be easily designed so that the relative dielectric constant of the entire film at 1 kHz and 25°C is 3 or more, 4 or more, 5 or more, or 6 or more, by adding an appropriate amount of a highly dielectric functional group such as a fluoroalkyl group, using a highly dielectric filler, and the like.

The organopolysiloxane cured product film, which is the dielectric layer, can be designed to have the following mechanical properties measured when heated and molded into a sheet having a thickness of 2.0 mm, based on JIS K 6249.
(1) The Young's modulus (MPa) at room temperature is 10 MPa or less, particularly preferably within a range of 0.1 to 2.5 MPa.
(2) The tear strength (N/mm) at room temperature is 1 N/mm or higher, particularly preferably within a range of 2 N/mm or higher.
(3) The tensile strength (MPa) at room temperature is 1 MPa or higher, particularly preferably within a range of 2 MPa or higher.
(4) The elongation at break (%) can be 50% or higher, particularly preferably within a range of 100 to 1000%.

When the organopolysiloxane cured film, which is the dielectric layer, is used in an application as an electronic material such as a touch panel and the like, electronic member for a display device, and particularly a transducer material such as a sensor or the like, the shear storage modulus at 23°C is preferably within a range of 10³ to 10⁵ Pa, more preferably 1.0 × 10³ to 5.0 × 10⁴ Pa.

As described above, the organopolysiloxane cured film, which is the dielectric layer, has an average thickness within the range of 1 to 200 µm per sheet, but a plurality of films may be superimposed to form a laminated film having a thickness of more than 200 µm, for the purpose of forming the dielectric layer.

### [Formation of the laminate body]

The laminate body can be preferably obtained, for example, by the method for producing a laminate body, including:
Step I: a step of obtaining an organopolysiloxane cured film as a dielectric layer by curing a curable organopolysiloxane composition that provides a dielectric layer by curing into a film shape; and
Step II: a step of applying the hot-melt electrode layer-forming organopolysiloxane composition after heat melting, onto the organopolysiloxane cured film or a precursor thereof, which has been subjected to Step I, to form an electrode layer, simultaneously with or after Step I. It should be noted that the application after heating and melting in Step II includes a step of applying the heated and melted composition by hot dispensing or the like to the portion of the dielectric layer or precursor thereof where an electrode layer is to be formed, and a step of placing a sheet-like or other molded product on the dielectric layer or precursor thereof where an electrode layer is to be formed, heating the product to 80°C or higher, and then applying the liquefied composition to the location. Furthermore, formation of the electrode layer includes either formation of the electrode layer by drying and solidifying the composition by cooling after heating and melting, or formation of the electrode layer as a cured product by a curing reaction of the composition after heating and melting.

In particular, when the curing reaction for forming the dielectric layer in Step I and the formation of the electrode layer in Step II are curing reactions accompanied by the formation of a cured product, and these curing reactions both include a hydrosilylation reaction, a structure can be provided in which both layers are chemically bonded to each other at the interface between the dielectric layer and the electrode layer by a hydrosilylation reaction, and the conformability and shape retention of the electrode layer of the present invention to the dielectric layer can be further improved, and peeling of the electrode layer and the occurrence of defects can be suppressed by selecting compositions in which the number of silicon-bonded hydrogen atoms in the organohydrogenpolysiloxane components are different from one another relative to 1 mol of the total amount of carbon-carbon double bonds in the curable organopolysiloxane composition for forming the dielectric layer or the hot-melt electrode layer-forming organopolysiloxane composition.

As one example, the SiH/Vi ratio ([SiH/Vi]_{Elec}) of the hot-melt electrode layer-forming organopolysiloxane composition of the present invention is particularly preferably 0.2 mol or more and 1.5 mol or less, preferably 0.3 mol or more and 1.2 mol or less, and more preferably 0.3 mol or more and 1.0 mol or less, and the SiH/Vi ratio ([SiH/Vi]_{DEAP}) of the curable organopolysiloxane composition forming the dielectric layer is particularly preferably such that the value of [SiH/Vi]_{Elec}/[SiH/Vi]_{DEAP} is in a range of 0.20 to 0.90, 0.33 to 0.85, 0.50 to 0.75, or 0.58 to 0.67. In other words, combinations in which the compositions forming the dielectric layer have some SiH excess are particularly preferable. When these curable organopolysiloxane compositions are cured by a hydrosilylation reaction, an excess amount of SiH groups present on the dielectric layer side at the interface are likely to undergo a hydrosilylation reaction with the curable reactive groups containing a carbon-carbon double bond in the electrode layer-forming organopolysiloxane composition at the interface between the two layers, facilitating provision of a structure in which the two layers are chemically bonded. The production method is particularly useful as a method for forming an electrode layer in a transducer member, and can industrially easily provide a laminate body, electronic component, or display device member, in which the dielectric layer and electrode layer are firmly joined, and thus peeling or defect problems due to lack of adhesive strength and tracking are less likely to occur.

The laminate body of organopolysiloxane cured films according to the present invention is useful as an electronic material, a member for a displaying device, and a member for a transducer (including sensors, speakers, actuators, and generators), and can be particularly preferably used as an electroactive film (including high dielectric films) provided with an electrode layer, an electronic component or a member for a displaying device. Furthermore, as described above, an electroactive film having high dielectric breakdown strength is suitable for transducer components such as actuators in the form of a single layer or laminate film, and the electrode layer according to the present invention can be formed on a dielectric layer without particular restriction, even in a solvent-free process involving heat melting or an electrode printing process. The electroactive film also has the characteristics of having extremely excellent conformity and shape retention with respect to the organopolysiloxane cured film, which is the dielectric layer, and being unlikely to cause problems such as peeling of the electrode layer, and is therefore particularly useful for actuator applications that start up under high voltage.

It should be noted that the organopolysiloxane cured film laminate body according to the present invention preferably has a whole or partial structure in which an electrode layer is provided on one side of the dielectric layer, these layers are alternately laminated, and the electrode layer is provided on the outer side. Furthermore, the laminate body of the present invention may have an electrode layer of the present invention and a single or multilayered dielectric layer, as well as a pressure-sensitive adhesive layer used for placing in a transducer, or a non-silicone thermoplastic resin layer that may optionally have a release surface.

### EXAMPLES

The present invention will be described below by way of examples; however, the present invention is not limited thereto. The following compounds were used in the examples shown below.
· Component (a1-1): Dimethylsiloxane polymer (amount of vinyl groups: 0.09 mass%, degree of siloxane polymerization: 835) blocked at both ends with a vinyldimethylsiloxy group
·Component (a1-2): Dimethylsiloxane polymer (amount of vinyl groups: 1.53 mass%, degree of siloxane polymerization: 45) blocked at both ends with a vinyldimethylsiloxy group
·Component (b-1): A vinyl-containing MQ resin composed of trimethylsiloxy units (M), vinyldimethylsiloxy units (ViM), and tetrafunctional siloxy units (Q, SiO_{4/2}) (vinyl group content: 1.9 mass%, polystyrene-equivalent weight average molecular weight Mw = 2.4 x 10⁴ measured by GPC (gel permeation chromatography) using tetrahydrofuran as a solvent)
· Component (b-2): MQ resin composed of trimethylsiloxy units (M) and tetrafunctional siloxy units (Q, SiO_{4/2}) units (polystyrene-equivalent weight average molecular weight Mw = 6.4 x 10³, measured by GPC using toluene as a solvent)
· Component (b-3): MQ resin composed of trimethylsiloxy units (M) and tetrafunctional siloxy units (Q, SiO_{4/2}) units (polystyrene-equivalent weight average molecular weight Mw = 3.4 x 10³, measured by GPC using toluene as a solvent)
· Component (c-1): Dimethylsiloxane polymer blocked at both ends with a dimethyhydrosiloxy group (amount of silicon-bonded hydrogen: 0.123 mass%)
· Component (c-2): Dimethylsiloxy-methylhydrosiloxy-siloxane copolymer blocked at both ends with a trimethylsiloxy group (amount of silicon-bonded water: 0.71 mass%)
·Component (d1): Masterbatch of platinum catalyst-containing fine particles (*)
(*) A master batch containing platinum catalyst-containing fine particles prepared by the method described in the Reference Example below (platinum metal concentration: 0.16 mass%)

### Reference example (Preparation of masterbatch containing platinum catalyst-containing thermoplastic resin fine particles)

900 g of bisphenol A thermoplastic polycarbonate resin (glass transition temperature (Tg) 145°C; wall material), 500 g of toluene, and 4600 g of dichloromethane were placed in a flask equipped with a stirrer, and mixed uniformly. 44.4 g of a divinyltetramethyldisiloxane solution of platinum (zero valence) divinyltetramethyldisiloxane complex (platinum metal concentration: 5 mass%) was added and mixed to obtain a homogeneous solution. This solution was sprayed and dried using a spray dryer using a hot nitrogen gas stream to obtain 450 g of spherical platinum catalyst-containing thermoplastic resin fine particles (average particle size: 1.1 µm).

Next, 40 parts by mass of the above platinum catalyst-containing thermoplastic resin fine particles were mixed with 60 parts by mass of dimethylpolysiloxane having a viscosity of 350 mPa·s and a vinyl group content of 0.47 mass%, both ends of the molecular chain of which were blocked with dimethylvinylsiloxy groups, to prepare a master batch containing platinum catalyst-containing fine particles. The concentration of platinum metal in the master batch was 0.16 mass%.
· Component (d2): Dimethyl siloxane polymer solution blocked at both ends by a vinyldimethylsiloxy group of a platinum-1,3-divinyl 1,1,3,3-tetramethyldisiloxane complex (platinum concentration approximately 0.6 mass%)

### <Conductive filler>

· Component (e): Single-walled carbon nanotubes (SWCNT, 10 mass% in dimethylsiloxane polymer capped with trimethylsiloxy groups at both ends, TUBALL^{™} MATRIX 601)

<Hydrosilylation reaction inhibitor>
▪ Component (f): 1-ethynylcyclohexanol

### [Examples 1 to 4, Comparative Examples 1 to 4]

Table 1 (Examples) and Table 2 (Comparative Examples) show the composition of each test example. The numerical value corresponding to each component is in mass%, and the sum thereof is 100 mass%. Furthermore, in the following examples, except for Example 1, component (c) was used in an amount such that the amount of silicon-bonded hydrogen atoms (Si-H) was 0.35 to 0.46 mol per mole of vinyl groups (unsaturated hydrocarbon groups, the same applies hereinafter) in the composition. Furthermore, Tables 1 and 2 show the physical properties before or after curing measured by the following methods.

### [Volume fraction of each component]

In the present invention, the true density of each component in the composition was defined as follows, and the volume fraction was calculated. Component (b) was 1.23 g/cc, the single-walled carbon nanotubes (SWCNT) in component (e) were 1.58 g/cc, and the other components were 0.98 g/cc.

### [Mw of component (b)]

The Mw when component (b) was blended and used was calculated as follows.

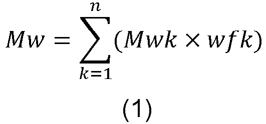

In the above formula (1), Mwk and wfk are the Mw of the kth component (b) and the weight fraction in all of component (b), respectively.

### [Sample preparation]

All ingredients except for component (d) were weighed into a 300 cc widemouth glass sample bottle and then heated in an oven at 125°C for approximately 30 minutes. Thereafter, the mixture was mixed with an electric stirrer on a hot plate heated to 180°C for 30 minutes or more while scraping off any deposits on the walls of the sample bottle. After cooling, component (d) was added, and the mixture was mixed with an electric stirrer on a hot plate heated to 120°C for 30 minutes or more while similarly scraping the mixture. The mixture was then transferred to a 100 cc HDPE container and heated in an oven at 110°C for 10 minutes or more. The mixture was removed from the oven and mixed for at least 4 minutes using a Thinky mixer (ARE-310) at a rotation speed of 2000 RPM.

### [Viscoelasticity measurement]

The storage modulus was measured using a viscoelasticity measuring device (Anton Paar, model number MCR302). An appropriate amount of each curable composition was placed on a lower plate having a Peltier element temperature control system heated to 120°C, and a parallel plate having a diameter of 15 mm was used to set the thickness of the sample to about 1.5 mm. Under conditions of a frequency of 1 Hz and a strain of 0.1%, the specimen was cooled at 3°C per minute to -20°C, then heated to 150°C and held for 180 minutes to cure. However, Example 1 was not cured. The cooling and heating was then repeated once more. The storage modulus (G') and loss tangent (tan δ) before and after curing at 25°C and 110°C are shown in Tables 1 and 2. It should be noted that when the ratio of the G' value before curing at 110°C to the G' value before curing at 25°C is 0.5 or less, the processability is excellent.

### Production of Cured Product

A mold having a size of 50 mm in length x 50 mm in width x 2 mm thick was placed on a metal plate, and a PTFE film (thickness: 150 micrometers) was placed thereon. An appropriate amount of each composition was placed on a PTFE film and heated in an oven at 120°C for 30 minutes or more. After removing from the oven, a PTFE film was placed on top of the composition, and the composition was further sandwiched between metal plates. Thereafter, the composition was press cured at 150°C for 15 minutes, and then post cured in an oven at 150°C for 45 minutes to obtain a sheet-like cured product (a sheet-like molded product not involving a curing reaction for the case of Example 1).

### [Volume resistance measurement VR]

A sheet approximately 2 mm thick was prepared under the above conditions, and the measurement was carried out at approximately 25°C using a LORESTA-GP MCP-T610 (PSP probe, manufactured by Mitsubishi Chemical Analytech). The values calculated using correction factors according to the sample shape are shown in Tables 1 and 2.

**[Table 1]**

| Example | | Example 1 | Example 2 | Example 3 | Example 4 |
|---|---|---|---|---|---|
| Component (a1-1) | | 25.20 | 23.72 | 25.04 | 29.57 |
| Component (a1-2) | | | | | |
| Component (b1) | | 20.58 | 19.37 | 19.38 | 17.49 |
| Component (b2) | | 38.22 | 35.98 | 36.00 | 32.49 |
| Component (b3) | | | | | |
| Component (c1) | | | 5.57 | 4.23 | 5.10 |
| Component (c2) | | | | | |
| Component (d) | | | 0.24 | 0.24 | 0.24 |
| Component (e) | | 16.00 | 15.11 | 15.11 | 15.11 |
| Component (f) | | | 0.01 | 0.01 | 0.01 |
| SiH/Vi | | NA | 0.46 | 0.35 | 0.46 |
| SWCNT volume fraction | | 0.011 | 0.011 | 0.011 | 0.010 |
| Volume fraction of component B | | 0.54 | 0.50 | 0.50 | 0.45 |
| Component B Mw | | 1.3×10⁴ | 1.3×10⁴ | 1.3×10⁴ | 1.3×10⁴ |
| G'_{25°C} (Pa) | Before curing | 1.5×10⁶ | 2.8×10⁵ | 3.7×10⁵ | 1.8×10⁵ |
| | After curing | NA | 2.7×10⁶ | 2.1×10⁶ | 1.8×10⁶ |
| tan *δ* 25°C | Before curing | 0.85 | 0.71 | 0.95 | 0.43 |
| | After curing | NA | 0.37 | 0.46 | 0.32 |
| G' 110°C (Pa) | Before curing | 6.5×10⁴ | 6.2×10⁴ | 4.9×10⁴ | 6.9×10⁴ |
| | After curing | NA | 4.0×10⁵ | 3.3×10⁵ | 4.4×10⁵ |
| tan *δ* 110°C | Before curing | 0.47 | 0.29 | 0.35 | 0.25 |
| | After curing | NA | 0.44 | 0.45 | 0.36 |
| Before curing G'_{110°C}/_{G'25°C} | | 0.04 | 0.22 | 0.13 | 0.38 |
| VR/ Ω·cm | | 5.2×10² | 6.3×10¹ | 1.9×10² | 9.2×10¹ |

**[Table 2]**

| Example | | Comparative Example 1 | Comparative Example 2 | Comparative example 3 | Comparative example 4 |
|---|---|---|---|---|---|
| Component (a1-1) | | 40.31 | 51.19 | 84.24 | |
| Component (a1-2) | | | | | 28.32 |
| Component (b1) | | 14.01 | 10.49 | | |
| Component (b2) | | 26.03 | 19.47 | | |
| Component (b3) | | | | | 54.95 |
| Component (c1) | | 4.30 | 3.50 | | |
| Component (c2) | | | | 0.41 | 1.38 |
| Component (d) | | 0.24 | 0.24 | 0.24 | 0.24 |
| Component (e) | | 15.11 | 15.11 | 15.11 | 15.11 |
| Component (f) | | 0.01 | 0.01 | 0.01 | 0.01 |
| SiH/Vi | | 0.46 | 0.46 | 1.00 | 0.60 |
| SWCNT volume fraction | | 0.010 | 0.010 | 0.009 | 0.011 |
| Volume fraction of component B | | 0.35 | 0.26 | 0 | 0.50 |
| Component B Mw | | 1.3×10⁴ | 1.3×10⁴ | NA | 3.4×10³ |
| G'25°C (Pa) | Before curing | 8.9×10⁴ | 7.0×10⁴ | 1.3×10⁴ | 3.7×10⁴ |
| | After curing | 6.1×10⁵ | 2.9×10⁵ | 6.8×10⁴ | 9.2×10⁴ |
| tan *δ* 25°C | Before curing | 0.25 | 0.24 | 0.27 | 0.27 |
| | After curing | 0.26 | 0.25 | 0.26 | 0.23 |
| G' 110°C (Pa) | Before curing | 5.1×10⁴ | 4.6×10⁴ | 9.8×10³ | 2.1×10⁴ |
| | After curing | 2.4×10⁵ | 1.5×10⁵ | 6.3×10⁴ | 5.6×10⁴ |
| tan *δ* 110°C | Before curing | 0.22 | 0.21 | 0.16 | 0.20 |
| | After curing | 0.27 | 0.23 | 0.18 | 0.17 |
| Before curing G'_{110°C}/_{G'25°C} | | 0.57 | 0.66 | 0.75 | 0.57 |
| VR/ Ω·cm | | 9.1×10¹ | 4.4×10¹ | 5.0×10¹ | 1.5×10¹ |

### [Summary]

As described above, in Examples 1 to 4, the temperature dependency of the viscoelasticity of the composition before curing is high, and the ratio of the value of G'_{11o°C} to the value of G'_{25°C} before curing is 0.5 or less. Therefore, the composition is easily softened by heating and has excellent coatability. In Example 1, an electrode layer having the viscoelasticity and temperature dependency shown in Table 1 can be formed by drying and solidifying after melting. In addition, in Examples 2 to 4, after the heat melting, the electrode layer (film) can be obtained as a cured product having appropriate viscoelasticity by heating and curing at a temperature equal to or higher than the glass transition point (Tg) of the wall material of component (d). Here, the volume resistivity of each electrode layer sheet in Examples 1 to 4 was kept low at 10² Ω·cm or less, and the sheets have excellent performance in terms of conductivity in addition to the aforementioned viscoelastic properties, as an electrode layer for various transducer applications including actuators.

On the other hand, in Comparative Examples 1 and 2, the weight percentage of component (b) is lower than 45%, so the temperature dependency of viscoelasticity is small. In Comparative Example 3, component (b) is not present, so the temperature dependency of viscoelasticity is hardly observed. Therefore, there is no improvement in processability due to heating, and even if the coating is applied, maintaining the shape is difficult. Furthermore, in Comparative Example 4, the Mw of component (b) is small, and even when formulated such that the volume fraction is 0.5, the temperature dependence of viscoelasticity is small. Therefore, the volume fraction of the conductive fine particles cannot be easily reduced, and the degrees of freedom for improving the composition of the electrode layer-forming composition is greatly restricted.

## Claims

1. A hot-melt electrode layer-forming organopolysiloxane composition, comprising:
(A) a linear organopolysiloxane;
(B) an organopolysiloxane resin having a weight average molecular weight of 5000 or higher in terms of a polystyrene standard, and containing siloxane units (M units) expressed by R₃SiO_{1/2} (where each R independently represents a monovalent organic group) and siloxane units (Q units) expressed by SiO_{4/2} in each molecule; and
(E) conductive fine particles,
wherein the hot-melt electrode layer-forming organopolysiloxane composition is non-flowable at 25°C and is heat meltable, and the amount of component (B) in the composition is 45 mass% or more based on the entire composition.

2. The hot-melt electrode layer-forming curable organopolysiloxane composition according to claim 1, wherein the ratio (G'_{110°C}/G'_{25°C}) of the shear storage modulus at 100°C (G'_{110°C}) to the shear storage modulus at 25°C (G'_{25°C}) of the composition before electrode formation is 0.5 or less.

3. The hot-melt electrode layer-forming organopolysiloxane composition according to claim 1, wherein the conductive fine particles are fine particles containing at least one type of conductive carbon selected from the group consisting of carbon nanotubes (CNT), conductive carbon black, graphite, and vapor grown carbon (VGCF).

4. The hot-melt electrode layer-forming organopolysiloxane composition according to claim 1, wherein the conductive fine particles are fine particles containing single-walled carbon nanotubes (SWCNT).

5. The hot-melt electrode layer-forming organopolysiloxane composition according to claim 1, wherein the volume fraction of conductive fine particles relative to the entire composition is in a range of 0.005 to 0.50, and the volume resistivity of an electrode layer obtained using the present composition is 10² Ω·cm or less.

6. The hot-melt electrode layer-forming organopolysiloxane composition according to claim 1, comprising:
(A1) a linear organopolysiloxane having a curing reactive functional group containing a carbon-carbon double bond at least at both ends of the molecular chain;
(B) an organopolysiloxane resin having a weight average molecular weight of 5000 or higher in terms of a polystyrene standard, and containing siloxane units (M units) expressed by R₃SiO_{1/2} (where each R independently represents a monovalent organic group) and siloxane units (Q units) expressed by SiO_{4/2} in each molecule;
(C) an organohydrogenpolysiloxane having at least two silicon-bonded hydrogen atoms in each molecule in an amount such that the amount of silicon-bonded hydrogen atoms in the composition is 0.0 to 1.5 mol per mole of total carbon-carbon double bonds in the composition;
(D) an effective amount of a hydrosilylation reaction catalyst; and
(E1) conductive fine particles containing single-walled carbon nanotubes (SWCNT),
wherein the volume fraction of the single-walled carbon nanotubes (SWCNT) relative to the entire composition is in a range of 0.005 to 0.25.

7. The organopolysiloxane composition according to claim 6, wherein at least a portion of component (C) is (C1) an organohydrogenpolysiloxane having silicon-bonded hydrogen atoms only at both ends of the molecular chain, and the amount of silicon -bonded hydrogen atoms in component (C) is 0.1 to 1.00 mol per mole of the total number of carbon-carbon double bonds in the composition.

8. The hot-melt electrode layer-forming organopolysiloxane composition according to claim 6, wherein at least a portion of component (D) is (D1) thermoplastic resin fine particles containing a platinum-containing hydrosilylation reaction catalyst.

9. A laminate body, comprising:
a structure in which two or more layers of organopolysiloxane cured film having different compositions are laminated; and
a structure in which (L2) an electrode layer made of the organopolysiloxane composition according to any one of claims 1 to 8 is laminated on at least one surface of (L1) the organopolysiloxane cured film which is a dielectric layer.

10. The laminate body according to claim 9, having a structure where
(L1) an organopolysiloxane cured film, a dielectric layer, is a cured film obtained by curing through a hydrosilylation reaction,
(L2-1) an electrode layer is made of the hot-melt electrode layer-forming organopolysiloxane composition according to any one of claims 6 to 8, and
the organopolysiloxane cured film serving as the dielectric layer and the electrode layer are chemically bonded at the interface.

11. A transducer member, comprising the laminate body according to claim 9 or claim 10.

12. A transducer, comprising the laminate body according to claim 9 or claim 10.

13. An electronic component or a display device, comprising the laminate body according to claim 9 or claim 10.

14. The method for producing a laminate body according to claim 9 or claim 10, comprising:
Step I: a step of obtaining an organopolysiloxane cured film as a dielectric layer by curing a curable organopolysiloxane composition that provides a dielectric layer by curing into a film shape; and
Step II: a step of applying the hot-melt electrode layer-forming organopolysiloxane composition according to any one of claims 1 to 8 after heat melting, onto the organopolysiloxane cured film or a precursor thereof, which has been subjected to Step I, to form an electrode layer, simultaneously with or after Step I.

15. A method for producing an electrode layer in a transducer member, comprising the method for producing a laminate body according to claim 14.
